# EUROPEAN PATENT APPLICATION

(11) **EP 4 716 428 A1**
(43) Date of publication of application: **25.03.2026**
(21) Application number: 25195066.3
(22) Date of filing: 11.08.2025
(51) Int. Cl.: H10H 29/49, H10H 29/85, H05K 1/02, H05K 1/181

(54) **MULTILAYER BOARD STRUCTURE AND DISPLAY DEVICE**

(30) Priority: 18.09.2024 JP 2024160933
(71) Applicant: ALPS ALPINE CO., LTD., Ota-ku Tokyo 145-8501 (JP)
(72) Inventor: Yasumoto, Takashi, Iwaki-City (JP)
(74) Representative: Schmitt-Nilson Schraud Waibel Wohlfrom Patentanwälte Partnerschaft mbB

(57) **Abstract**

A multilayer board structure includes a plurality of light emitting devices, each light emitting device of the plurality of light emitting devices having a plurality of electrodes formed on a terminal surface thereof, and a multilayer board including a plurality of stacked substrates and implemented with the plurality of light emitting devices. An uppermost substrate of the plurality of stacked substrates has a surface formed with metal layers coupling electrodes of the plurality of light emitting devices. Remaining substrates of the plurality of stacked substrates, other than the uppermost substrate, have surfaces formed with metal layers, respectively. A number of metal layers located directly below the electrodes of the plurality of light emitting devices is the same for each of the electrodes.

## Description

The present disclosure relates to multilayer board structures, and display devices having a plurality of light emitting elements disposed on a board. The present disclosure relates particularly to multilayer board structures for implementing micro light emitting diodes (LEDs).

In recent years, micro LEDs, which can directly display an image or video from the light emitting diodes (LEDs), have been developed. The micro LEDs are arranged two-dimensionally so as to correspond to pixels. For example, anodes of the LEDs are coupled in common to a data wiring, and cathodes of the LEDs are coupled to scan wirings, thereby enabling each of the LEDs to be driven (refer to JP 2021-504752 A, for example).

Display devices, such as liquid crystal displays (LCDs), organic LEDs (OLEDs), or the like, have a structure including a hard board formed of glass or the like, and cannot be bent. However, in recent years, curved displays that enhance immersion have been commercialized. Such curved displays are made by melting glass to form a thin glass, and forcibly attaching and fixing the thin glass along a housing. In addition, development and commercialization of display devices having a soft base, such as a film or the like, formed with circuits and implementing micro LEDs, are being considered.

There are demands to improve heat dissipation while preventing implementation defects of light emitting devices in multilayer board structures and display devices.

The present disclosure relates to a multilayer board structure and display device according to the appended claims. Embodiments are disclosed in the dependent claims.

According to an aspect of embodiments of the present disclosure, a multilayer board structure includes a plurality of light emitting devices, each light emitting device of the plurality of light emitting devices having a plurality of electrodes formed on a terminal surface thereof; and a multilayer board including a plurality of stacked substrates and implemented with the plurality of light emitting devices, wherein an uppermost substrate of the plurality of stacked substrates has a surface formed with metal layers coupling electrodes of the plurality of light emitting devices, remaining substrates of the plurality of stacked substrates, other than the uppermost substrate, have surfaces formed with metal layers, respectively, and a number of metal layers located directly below the electrodes of the plurality of light emitting devices is the same for each of the electrodes.

The object and advantages of the embodiments will be realized and attained by means of the elements and combinations particularly pointed out in the claims.

It is to be understood that both the foregoing general description and the following detailed description are exemplary and explanatory and not restrictive of the invention, as claimed.
FIG. 1A is a top view illustrating an example of an LED device;
FIG. 1B is a bottom view illustrating the example of the LED device;
FIG. 1C is a diagram illustrating a cathode common connection;
FIG. 1D is a diagram illustrating an anode common connection;
FIG. 2A is a cross sectional view illustrating an example of a multilayer board structure;
FIG. 2B is a cross sectional view for explaining a problem m1 of the example of the multilayer board structure;
FIG. 3A is a cross sectional view for explaining a problem m2 of the example of the multilayer board structure;
FIG. 3B is a cross sectional view for explaining a problem m3 of the example of the multilayer board structure;
FIG. 4A is a cross sectional view for explaining a problem m4 of the example of the multilayer board structure;
FIG. 4B is a cross sectional view for explaining a problem m5 of the example of the multilayer board structure;
FIG. 5A is a plan view illustrating a relationship between LED devices and interconnects (metal patterns) for explaining a problem m6 of the example of the multilayer board structure;
FIG. 5B is a plan view illustrating a relationship between the LED devices and the interconnects (the metal patterns) for explaining a problem m7 of the example of the multilayer board structure;
FIG. 5C is a plan view illustrating a relationship between the LED devices and the interconnects (the metal patterns) for explaining the problem m7 of the example of the multilayer board structure;
FIG. 6A and FIG. 6B are cross sectional views schematically illustrating a configuration of a multilayer board structure according to one embodiment of the present disclosure;
FIG. 7A is a plan view illustrating a first metal pattern of the multilayer board structure according to one embodiment of the present disclosure;
FIG. 7B is a plan view illustrating a second metal pattern of the multilayer board structure according to one embodiment of the present disclosure;
FIG. 8A is a plan view illustrating a third metal pattern of the multilayer board structure according to one embodiment of the present disclosure; and
FIG. 8B is a plan view illustrating a fourth metal pattern of the multilayer board structure according to one embodiment of the present disclosure.

A description will be given of examples of an LED device and a multilayer board structure.

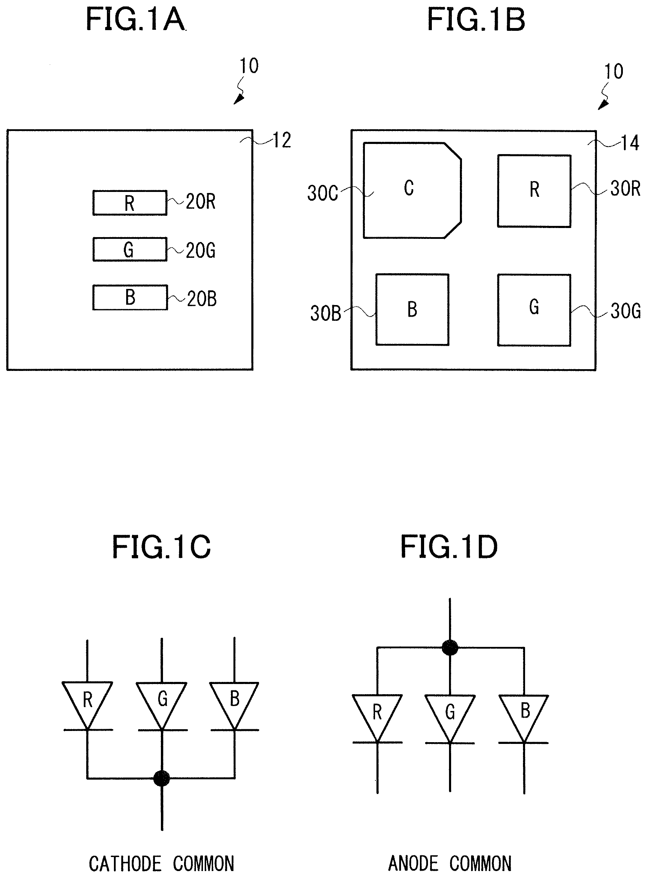

FIG. 1A is a top view illustrating an example of the LED device, and FIG. 1B is a bottom view illustrating the example of the LED device. FIG. 1C is a diagram illustrating a cathode common connection, and FIG. 1D is a diagram illustrating an anode common connection. An LED device 10 includes a rectangular package, for example. Three light emitting elements configured to emit red (R) light, green (G) light, and blue (B) light, respectively, are provided inside the package of the LED device 10. As illustrated in FIG. 1A, an upper surface 12 of the package includes light emitting portions 20R, 20G, and 20B of the R, G, and B light emitting elements, respectively. One LED device 10 constitutes one pixel, and the R, G, and B light emitting elements constitute subpixels.

A bottom surface 14 of the package of the LED device 10 is provided with R, G, and B electrodes 30R, 30G, and 30B, and a common (C) electrode 30C. The R electrode 30R is electrically connected to the R light emitting element, the G electrode 30G is electrically connected to the G light emitting element, the B electrodes 30B is electrically connected to the B light emitting element, and the C electrode 30C is electrically connected in common to cathodes or anodes of the R, G, and B light emitting elements. The arrangement, shape, size, or the like of the R, G, B, and C electrodes 30R, 30G, 30B, and 30C may be set arbitrarily, but the R, G, B, and C electrodes 30R, 30G, 30B, and 30C have substantially the same height. The size of the electrode 30C may be made larger than those of the electrodes 30R, 30G, and 30B in order to facilitate manufacturing processes at a manufacturer, or to facilitate user checks of the arrangements and orientations of constituent elements of the actual LED device, or to achieve efficient heat dissipation in a case of the cathode common connection illustrated in FIG. 1C because the cathode side of the LED becomes hotter than the anode side of the LED.

As illustrated in FIG. 1C, in the cathode common, cathode electrodes of the R, G, and B light emitting elements are connected in common to the electrode 30C, and anode electrodes of the R, G, and B light emitting elements are connected to the electrodes 30R, 30G, and 30B, respectively. On the other hand, as illustrated in FIG. 1D, in the anode common, the anode electrodes of the R, G, and B light emitting elements are connected in common to the electrode 30C, and the cathode electrodes of the R, G, and B light emitting elements are connected to the electrodes 30R, 30G, and 30B, respectively. The LED device 10 may be driven by either the cathode common or the anode common.

In a case where a board implemented with the LED device is not a rigid board (that is, a regular hard printed circuit board), but is a flexible board including thin films of polyimide, polyethylene terephthalate (PET), or the like that are stacked in multiple layers, the following problems m1 through m7 may occur.
m1. As the number of layers of a multilayer structure increases, a thickness of the board varies between a portion including a pattern (a copper foil or the like) and a portion including no pattern.
m2. Due to a difference in the thickness of the board between the portion including the pattern and the portion including no pattern, it may not be possible to connect circuit patterns and the electrodes (that is, an open-circuit state may occur) even when the LED device is implemented.
m3. When the LED device is implemented, the LEDs tilt due to the difference in the thickness of the board between the portion including the pattern and the portion including no pattern, thereby tilting an emission optical axis and deteriorating a front luminance.
m4. When the LED device is implemented, the LEDs tilt due to the difference in the thickness of the board between the portion including the pattern and the portion including no pattern, thereby preventing solder from adhering onto the electrodes (that is, an open-circuit state may occur).
m5. When the LED device is implemented, the LEDs tilt due to the difference in the thickness of the board between the portion including the pattern and the portion including no pattern, thereby causing the circuit pattern to come into contact with an electrode different from an intended electrode (that is, a short-circuit state may occur).
m6. When a heat dissipation pattern of the cathode is extracted from a layer (outermost layer) L1, the heat is not transferred uniformly, thereby causing a position of a component to shift.
m7. When the LED devices are implemented at a narrow pitch, heat cannot be dissipated efficiently from the cathode which becomes hot.

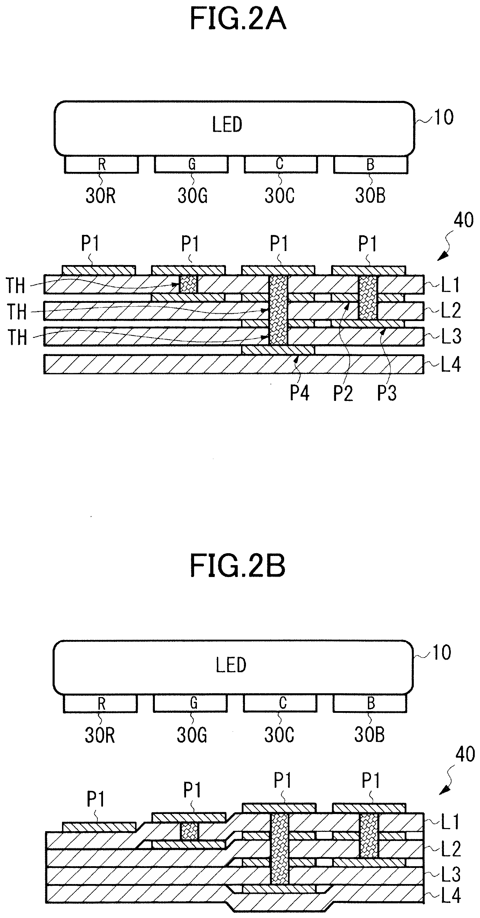

The problem m1 will be described with reference to FIG. 2A and FIG. 2B. FIG. 2A is a cross sectional view illustrating an example of a multilayer board implemented with the LED device. For the sake of convenience and ease of explanation, it is assumed that the electrodes 30R, 30G, 30C, and 30B of the LED device 10 are arranged in a linear direction.

A multilayer board 40 includes substrates L1, L2, L3, and L4 which are four film substrates that are stacked. Metal patterns P1, P2, P3, and P4 are formed on upper surfaces of the substrates L1, L2, L3, and L4, respectively. In addition, through holes TH filled with a metal material are formed in the substrates L1, L2, and L3. Each through hole TH electrically connects a metal pattern of an upper layer to a metal pattern of a lower layer.

The metal patterns P1 are formed at positions corresponding to the electrodes 30R, 30G, 30C, and 30B, and the electrodes 30R, 30G, 30C, and 30B are electrically connected to the corresponding metal patterns P1 by solder or the like. The electrode 30R is electrically connected to a driving circuit (not illustrated) via an interconnect of the metal pattern P1 on the substrate L1 of a first layer. The electrode 30G is electrically connected to the driving circuit via an interconnect of the metal pattern P2 on the substrate L2 of a second layer. The electrode 30C is electrically connected to the driving circuit via an interconnect of the metal pattern P4 on substrate L4 of a fourth layer. The electrode 30B is electrically connected to the driving circuit via an interconnect of the metal pattern P3 of the substrate L3 of a third layer.

Because the multilayer board 40 is formed by stacking thin films of polyimide, PET, or the like that is flexible, when the films are bonded together as illustrated in FIG. 2B, a height of the metal patterns P1 on the substrate L1 of an uppermost layer varies depending on the presence or absence of a metal pattern located below the metal patterns P1, thereby varying a thickness of the multilayer board 40.

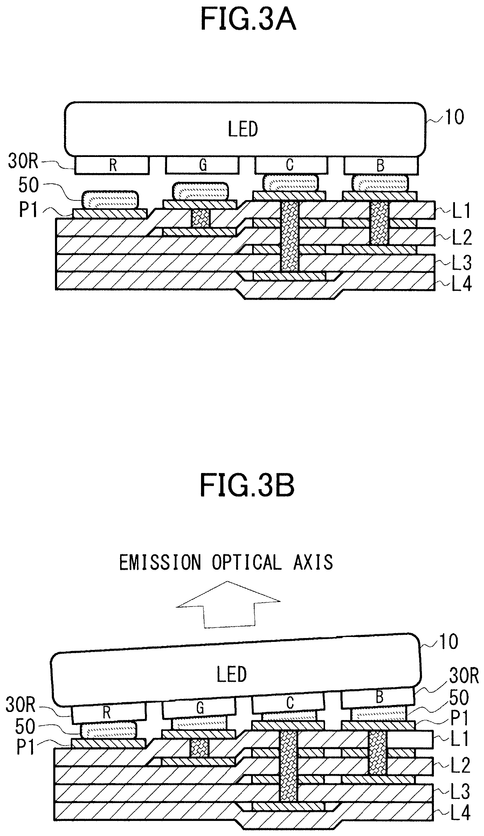

FIG. 3A is a diagram for explaining the problem m2. As described above for the problem m1, when the thickness of the multilayer board 40 varies, that is, when the heights of the metal patterns P1 on the substrate L1 of the first layer differ, a poor connection (or a connection failure) occurs (that is, an open-circuit state occurs) between the metal patterns P1 and the electrodes 30R, 30G, 30C, and 30B when the LED device 10 is implemented on the multilayer board 40. FIG. 3A illustrates an example in which the LED device 10 does not tilt, but solder 50 does not adhere onto the electrodes 30R and 30G, and the electrodes 30R and 30G are not electrically connected to the metal patterns P1.

FIG. 3B is a diagram for explaining problem m3. As described above for the problem m1, when the thickness of the multilayer board 40 varies, the LED device 10 tilts when the LED device 10 is implemented, thereby tilting emission optical axes of the light emitting portions 20R, 20G, and 20B of the LED device 10 and deteriorating a front luminance. FIG. 3B illustrates an example in which the electrodes 30R, 30G, 30C, and 30B are electrically connected to the metal patterns P1 via the solder 50, but the LED device 10 is tilted and the emission optical axes are tilted.

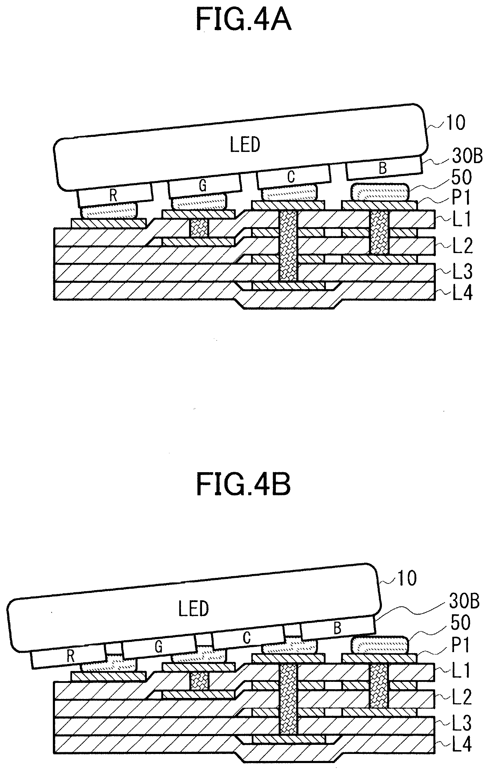

FIG. 4A is a diagram for explaining the problem m4. As described above for the problem m1, when the thickness of the multilayer board 40 varies, the LED device 10 tilts when the LED device 10 is implemented, thereby generating electrodes to which the solder 50 is not adhered (that is, generating an open-circuit state). FIG. 4A illustrates an example in which the LED device 10 tilts, thereby generating the electrode 30B to which the solder 50 is not adhered and preventing the electrode 30B from being electrically connected to the corresponding metal pattern P1. Thus, the blue light cannot be emitted in this example.

FIG. 4B is a diagram for explaining the problem m5. As described above for the problem m1, when the thickness of the multilayer board 40 varies, the LED device 10 tilts when the LED device 10 is implemented, thereby causing the metal pattern P1 to come into contact with an electrode different from an intended electrode (that is, a short-circuit state occurs). FIG. 4B illustrates an example in which the LED device 10 tilts and a position thereof shifts, thereby causing the metal pattern P1 to come into contact with an electrode adjacent the intended electrode. Thus, light of a color different from an intended color is emitted or the light of the intended color cannot emitted in this example.

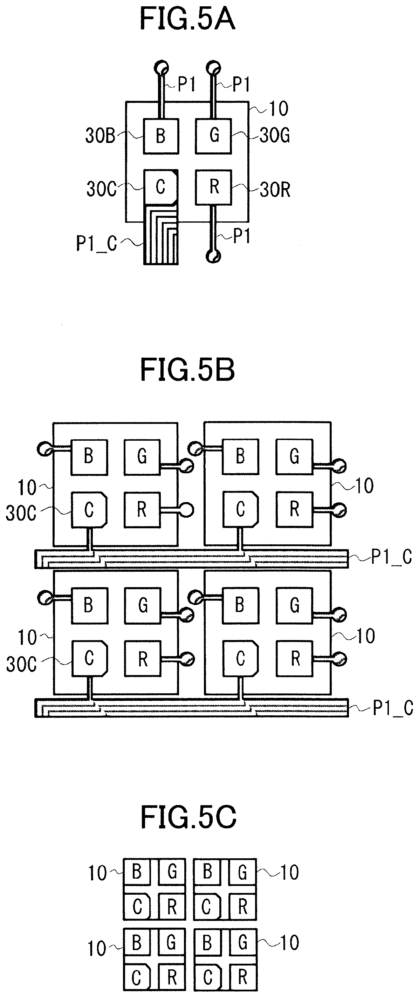

FIG. 5A is a diagram for explaining the problem m6. When a heat dissipation pattern of the cathode is extracted from the substrate L1 of the outermost layer, the heat is not transferred uniformly, thereby causing a position of a component to shift, lift, or rise, and a poor connection (or a connection failure) to occur between the metal patterns P1 and the electrodes 30R, 30G, 30C, and 30B. FIG. 5A illustrates an example in which a width of a metal pattern P1_C of the electrode 30C electrically connected to the cathode is greater than widths of the metal patterns P1 electrically connected to the electrodes 30R, 30G, and 30B of the LED device 10, in order to increase the heat dissipation.

FIG. 5B and FIG. 5C are diagrams for explaining the problem m7. In a case where the LED devices 10 are implemented at a narrow pitch, heat cannot be efficiently dissipated from the cathode which becomes hot. As illustrated in FIG. 5B, in a case where the LED devices 10 have a large size or are implemented at a large pitch, the metal pattern P1_C on the substrate L1 can be extracted to dissipate the heat by utilizing a space between the LED devices 10. However, as illustrated in FIG. 5C, in a case where the LED devices 10 have a small size or are implemented at a narrow pitch, it is difficult to dissipate the heat of the cathode electrode by utilizing the metal pattern P1 on the substrate L1.

There are demands to improve the heat dissipation while preventing implementation defects of light emitting devices in multilayer board structures and display devices. That is, it is desirable to eliminate the problems m1 through m7 described above.

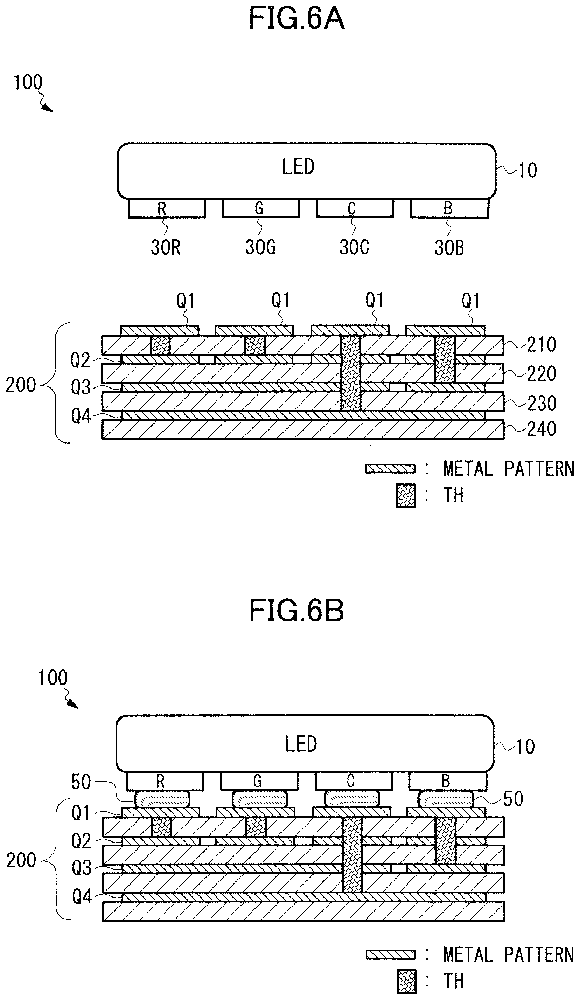

Next, a description will be given of embodiments of the present disclosure with reference to FIG. 6A through FIG. 8B.

The embodiments of the present disclosure relate to multilayer board structures implemented with a plurality of light emitting devices, and display devices using such multilayer board structures. The light emitting device includes micro LEDs in a package, for example, and in a case where the display device displays a color image, the light emitting device includes R, G, and B micro LEDs. The multilayer board includes a stack of flexible film substrates, and metal patterns formed on a surface of each of the flexible film substrates, as electrode pads, connection pads, dummy pads, or wiring patterns (or interconnect patterns, or circuit patterns). The drawings referred to in the following description may include exaggerated representations for facilitating the understanding of the present disclosure, and do not necessarily represent shapes or scales of constituent elements and actual devices (or products).

### [Embodiments]

FIG. 6A and 6B are cross sectional views schematically illustrating a multilayer board structure according to one embodiment of the present disclosure. FIG. 6A illustrates a state before implementing an LED device, and FIG. 6B illustrates a state after implementing the LED device. A multilayer board structure 100 according to the present embodiment includes a plurality of LED devices 10, and a multilayer board 200 implemented with the plurality of LED devices 10. The multilayer board structure 100 may be used for a display device, for example.

The LED device 10 illustrated in FIG. 6A and FIG. 6B is configured similarly to the LED device 10 illustrated in FIG. 1A and FIG. 1B, for example. That is, the LED device 10 includes a rectangular package, for example. Three light emitting elements configured to emit red (R) light, green (G) light, and blue (B) light, respectively, are provided inside the package. Hereinafter, the light emitting element configured to emit R light will be referred to as the "R light emitting element", the light emitting element configured to emit G light will be referred to as the "G light emitting element", and the light emitting element configured to emit B light will be referred to as the "B light emitting element". An upper surface (or a light emission surface) 12 of the package of the LED device 10 includes light emitting portions 20R, 20G, and 20B of the R, G, and B light emitting elements, respectively. A bottom surface (or a terminal surface) 14 of the package of the LED device 10 is provided with R, G, and B electrodes 30R, 30G, and 30B, and a common (C) electrode 30C. The R electrode 30R is electrically connected to the R light emitting element, the G electrode 30G is electrically connected to the G light emitting element, the B electrodes 30B is electrically connected to the B light emitting element, and the C electrode 30C is electrically connected in common to cathodes or anodes of the R, G, and B light emitting elements. Surfaces of the R, G, B, and C electrodes 30R, 30G, 30B, and 30C have substantially the same height. The surfaces of the electrodes 30R, 30G, 30B, and 30C may substantially coincide with the terminal surface of the package of the LED device 10, or may be slightly higher than the terminal surface of the package of the LED device 10. In the LED device 10 illustrated in FIG. 6A and FIG. 6B, the electrodes 30R, 30G, 30B, and 30C are linearly arranged for the sake of convenience and ease of explanation.

The multilayer board 200 includes a plurality of film substrates that are stacked, and metal patterns are formed on the surface of each film substrate of the plurality of film substrates. The metal patterns may include wiring patterns, interconnect patterns, or circuit patterns for transmitting electrical signals for driving the LED device 10, and dummy patterns for improving heat dissipation.

A material used for the film substrate is not particularly limited, and the film substrate may be formed of polyimide, PET, or the like, for example. Metal patterns formed of a single layer or stacked layers (or multiple layers) of copper (Cu), gold (Au), silver (Ag), silver magnesium (AgMg), aluminum (Al), or indium tin oxide (ITO) are formed on the surface of the film substrate. The metal patterns may be formed by depositing a metal material and etching the deposited metal material by a photolithography process, or by screen printing the metal material, for example. Further, through holes TH are formed in the film substrates. The through hole TH electrically connects a metal pattern of an upper layer to a metal pattern of a lower layer. The through holes TH are filled with a conductive material, such as Cu or the like, for example.

The multilayer board 200 illustrated in FIG. 6A and FIG. 6B is configured to include a stack of four substrates 210, 220, 230, and 240, for example. Metal patterns Q1 are formed on the upper surface of the uppermost substrate 210 of a first layer (hereinafter also referred to as the "first substrate 210") at positions corresponding to the electrodes 30R, 30G, 30B, and 30C of the LED device 10.

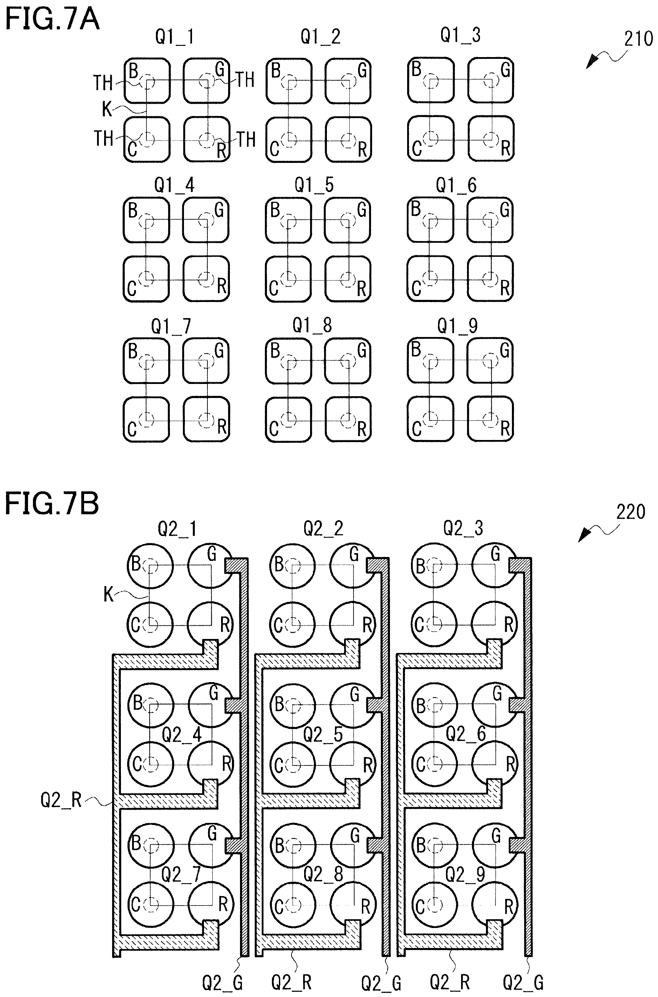

FIG. 7A is a plan view of the first substrate 210, and illustrates the metal patterns Q1 (Q1_1 through Q1_9) corresponding to 3 rows × 3 columns of the LED devices 10. For example, the metal pattern Q1_1 corresponding to one LED device 10 has four rectangular electrodes pads R, G, B, and C at positions corresponding to the electrodes 30R, 30G, 30B, and 30C. Through holes TH are formed directly below centers of the four electrode pads R, G, B, and C, respectively. The through holes TH penetrate the first substrate 210, and the through holes TH are filled with a metal material by copper-plating the through holes TH, for example, thereby enabling electrical connection of the upper and lower metal patterns.

Accordingly, the electrode pads R, G, B, and C are electrically connected to the through holes TH immediately below these electrode pads R, G, B, and C. In FIG. 7A, the through holes TH are indicated by circular broken lines for the sake of convenience and ease of explanation. In addition, a rectangular broken line K indicates a planar shape or outline of the LED device 10 when implemented. One side of the LED device 10 is 0.43 mm, for example, and a size of one electrode is 0.18 mm, for example.

Metal patterns Q2 are formed on the upper surface of the substrate 220 of a second layer (hereinafter also referred to as the "second layer 220"). The metal patterns Q2 include connection pads arranged below the electrode pads R, G, B, and C, respectively, an interconnect pattern for the R light emitting element, and an interconnect pattern for the G light emitting element. FIG. 7B is a plan view of the second substrate 220. The metal patterns Q2 include metal patterns Q2_1 through Q2_9 corresponding to the metal patterns Q1_1 through Q1_9 of the first substrate 210, interconnect patterns Q2_R for the R light emitting elements, and interconnect patterns Q2_G for the G light emitting elements.

For example, the metal pattern Q2_1 corresponding to one LED device 10 includes four connection pads R, G, B, and C. The connection pads R, G, B, and C of the metal pattern Q2_1 are located below the electrode pads R, G, B, and C of the upper layer, and are electrically connected to the electrode pads R, G, B, and C of the upper layer via the through holes TH, respectively. The shape of the connection pads R, G, B, and C of the metal pattern Q2_1 is not particularly limited, and is a circular shape, for example. The size of the connection pads R, G, B, and C of the metal pattern Q2_1 is substantially the same as that of the electrode pads R, G, B, and C.

The through holes TH are formed directly below centers of the connection pads B and C of the metal pattern Q2_1. However, no through holes TH are formed directly below the connection pads R and G of the metal pattern Q2_1. The through holes TH formed in the second substrate 220 are configured in a manner similar to the through holes TH formed in the first substrate 210.

The interconnect patterns Q2_R are formed to extend in column directions of the LED devices 10, and one interconnect pattern Q2_R is connected in common to the connection pads R in the same column (for example, the metal pattern Q2_1, Q2_4, or Q2_7). FIG. 7B illustrates the interconnect patterns Q2_R extending in three column directions.

Similarly, the interconnect patterns Q2_G are formed to extend in the column directions of the LED devices 10, and one interconnect pattern Q2_G is connected in common to the connection pads G in the same column (for example, the metal pattern Q2_1, Q2_4, or Q2_7). Although the metal patterns Q2 include the interconnect patterns Q2_R and the interconnect patterns Q2_G in this example, the present disclosure is not limited thereto, and for example, the metal patterns Q1 may include the interconnect pattern of either the R light emitting element or the G light emitting element, and the metal patterns Q2 may include the interconnect patterns of either the G light emitting elements or the R light emitting elements.

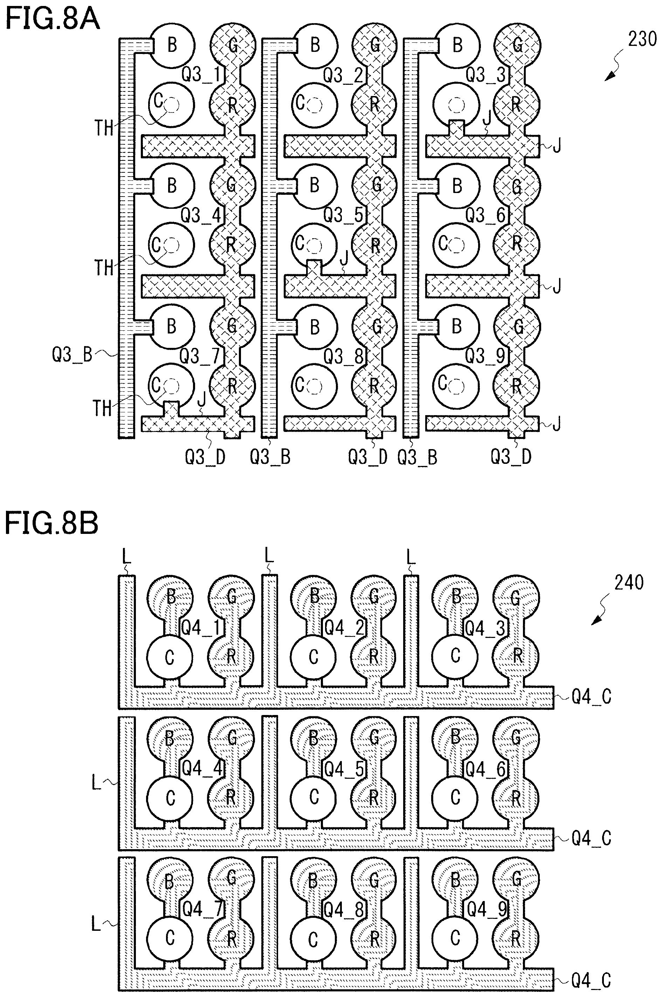

Metal patterns Q3 are formed on the upper surface of the substrate 230 of a third layer (hereinafter also referred to as the "third layer 230"). The metal patterns Q3 include connection pads arranged below the connection pads B and C of the metal patterns Q2, dummy pads arranged below the connection pads R and G of the metal patterns Q2, and an interconnect pattern for the B light emitting element. FIG. 8A is a plan view of the third substrate 230. The metal patterns Q3 include metal patterns Q3_1 through Q3_9 corresponding to the metal patterns Q2_1 through Q2_9, and interconnect patterns Q3_B for the B light emitting elements.

For example, the metal pattern Q3_1 corresponding to one LED device 10 includes two connection pads B and C, and two dummy pads R and G. The connection pads B and C of the metal pattern Q3_1 are located below the connection pads B and C of the metal patterns Q2 of the upper layer, respectively, and are electrically connected to the connection pads B and C of the metal patterns Q2 via the through holes TH. The shape of the connection pads B and C of the metal pattern Q3_1 is not particularly limited, and the connection pads B and C of the metal pattern Q3_1 may have a shape that is substantially the same as that of the connection pads B and C of the metal patterns Q2, for example. A through hole TH is formed directly below a center of the connection pad C of the metal pattern Q3_1. The through hole TH formed in the substrate 230 is configured in a manner similar to the through holes TH formed in the first substrate 210.

The dummy pads R and G of the metal pattern Q3_1 are arranged below the connection pads R and G of the metal patterns Q2. The shape of the dummy pads R and G of the metal pattern Q3_1 is not particularly limited, and the dummy pads R and G of the metal pattern Q3_1 may have a shape that is substantially the same as that of the connection pads R and G of the metal patterns Q2, for example. Because no through holes TH are present between the dummy pads R and G of the metal pattern Q3_1 and the connection pads R and G of the metal patterns Q2, the dummy pads R and G of the metal pattern Q3_1 and the connection pads R and G of the metal patterns Q2 are not electrically connected to one another. The dummy pads R and G in the same column direction are connected to each other so as to extend in the column direction, and connect extending portions J extending in empty spaces in row directions. The extending portion J is connected to any one of the connection pads C in the same column. In the example illustrated in FIG. 8A, the bottom left extending portion J is connected to the connection pad C of the metal pattern Q3_7, the center extending portion J is connected to the connection pad C of the metal pattern Q3_5, and the top right extending portion J is connected to the connection pad C of the metal pattern Q3_3. The dummy pads R and G and the extending portions J increase the area of the metal pattern connected to the C electrode, thereby improving the heat dissipation.

The interconnect patterns Q3_B are formed to extend in the column directions of the LED devices 10, and one interconnect pattern Q3_B is connected in common to the connection pads B in the same column (for example, the metal pattern Q3_1, Q3_4, or Q3_7). FIG. 8A illustrates the interconnect patterns Q3_B extending in three column directions.

Metal patterns Q4 are formed on the upper surface of the substrate 240 of a fourth layer (hereinafter also referred to as the "fourth layer 240"). The metal patterns Q4 include a connection pad C arranged below the connection pad C of the metal patterns Q3 of the upper layer, dummy pads R, G, and B arranged below the dummy pads R and G and the connection pad B of the metal patterns Q3, and an interconnect pattern of the electrode 30C. FIG. 8B is a plan view of the fourth substrate 240. The metal patterns Q4 include metal patterns Q4_1 through Q4_9 corresponding to the metal patterns Q3_1 through Q3_9, and common interconnect patterns Q4_C for the R, G, and B light emitting elements, respectively.

For example, the metal pattern Q4_1 corresponding to one LED device 10 includes one connection pad C and three dummy pads R, G, and B. The connection pad C of the metal pattern Q4_1 is located below the connection pad C of the metal patterns Q3 of the upper layer, and is electrically connected to the connection pad C of the metal patterns Q3 via the through hole TH. The shape of the connection pad C of the metal pattern Q4_1 is not particularly limited, and the connection pad C of the metal pattern Q4_1 may have a shape that is substantially the same as that of the connection pad C of the metal patterns Q3, for example.

The dummy pads R, G, and B of the metal pattern Q4_1 are located below the dummy pads R and G and the connection pad B of the metal patterns Q3 of the upper layer. The shape of the dummy pads R, G, and B of the metal pattern Q4_1 is not particularly limited, and may have a shape that is substantially the same as the dummy pads R and G and the connection pad B of the metal patterns Q3, for example. In one metal pattern Q4_1, for example, the dummy pads R and G are connected to each other, and the dummy pad B is connected to the connection pad C.

The interconnect patterns Q4_C are formed to extend in the row directions of the LED devices 10, and one interconnect pattern Q4_C is connected in common to the connection pads C in the same row (for example, the metal pattern Q4_1, Q4_2, or Q4_3). In addition, the interconnect pattern Q4_C connects extending portions L extending in empty spaces in the column directions. FIG. 8B illustrates interconnect patterns Q2_B extending in three row directions. The dummy pads R, G, and B and the extending portions L increase the area of the metal pattern connected to the C electrode, thereby improving the heat dissipation.

The substrates 210, 220, 230, and 240 are bonded and laminated to form the multilayer board 200. The flatness of the electrode pads R, G, B, and C of the first substrate 210 can be improved by making the number of metal patterns located immediately below the electrode pads R, G, B, and C of the first substrate 210 uniform. As illustrated in FIG. 6B, the solder 50 is formed on the electrode pads R, G, B, and C, the electrodes 30R, 30G, 30B, and 30C of the LED devices 10 are connected to the solder 50, and the LED devices 10 are implemented on the multilayer board 200.

The interconnect patterns Q2_R, Q2_G, Q3_B, and Q4_C of the respective layers of the multilayer board 200 are connected to the driving circuit (not illustrated). The LED device 10 located at an intersection of the R, G, and B driving signals applied via the interconnect patterns Q2_R, Q2_G, and Q3_B in the column direction and the common driving signal (for example, ground potential GND) applied via the interconnect pattern Q4_C in the row direction is selected, and lighting or illumination of the R, G, and B light emitting elements of the selected LED device 10 is controlled.

The multilayer board structure 100 according to the present embodiment can obtain the following advantageous features (or effects) f1 through f8.
f1. Although the board has the multilayer structure, the thickness of the board can be made uniform between a portion of the board including a pattern (copper foil) and a portion of the board including no pattern.
f2. Because the thickness of the board can be made uniform, even when the LED device is implemented, it is possible to reliably and electrically connect the electrodes the circuit patterns (metal patterns Q1) and the electrodes of the LED device.
f3. Because the thickness of the board can be made uniform, even when the LED device is implemented, the LED device does not tilt, and the emission optical axis is aligned to a normal direction with respect to the board, thereby improving the front luminance.
f4. Because the thickness of the board can be made uniform, even when the LED device is implemented, the LED device does not tilt, and the solder can be reliably adhered on all of the electrodes.
f5. Because the thickness of the board can be made uniform, even when the LED device is implemented, the LED device does not tilt, and it is possible to prevent the circuit patterns (or metal patterns Q1) from making contact with or making electrical connections to electrodes different from the intended electrodes.
f6. Because the heat dissipation pattern of the cathode is extracted from the substrate of a layer other than the first substrate (that is, other than the uppermost substrate of the first layer), heat is transferred uniformly during implementation (or mounting), and it is possible to prevent a positional shift of the component.
f7. When LED devices are implemented at a narrow pitch, the heat dissipation of the cathode which becomes hot can be performed efficiently using a plurality of layers.
f8. The metal patterns on the first substrate (that is, the uppermost substrate of the first layer) include only lands (electrode pads) for making electrical connections to the electrodes of the LED devices, and all of the electrodes are formed in the same shape. For this reason, it is possible to prevent a positional shift or rotation of the component.

The shape, size, or the like of the electrode pads, the connection pads, the dummy pads, the dummy interconnects, and the wiring patterns in the embodiments described above are merely examples, and the present disclosure is not limited thereto. In the embodiments described above, the number of the metal patterns Q1, Q2, Q3, and Q4 located directly below the electrodes of the LED device is set to coincide with the number of the stacked layers of the multilayer board. However, the number of the metal patterns Q1, Q2, Q3, and Q4 located directly below the electrodes of the LED device does not need to coincide with the number of the stacked layers of the multilayer board, as long as the number of metal patterns located directly below each of the electrodes of the LED device is the same. Hence, the number of metal patterns located directly below each of the electrodes of the LED device may be smaller than the number of layers of the multilayer board, for example.

According to the present disclosure, the metal layers are formed on the surfaces of the respective substrates so that the number of metal layers located directly below the electrodes of the light emitting device is the same. For this reason, it is possible to improve the flatness of the surface of the multilayer board, and to prevent implementation defects of the light emitting devices. Further, it is possible to improve the heat dissipation by the metal layer formed on the surface of the substrate other than the uppermost substrate of the multilayer board.

While certain embodiments have been described, these embodiments have been presented by way of example only, and are not intended to limit the scope of the disclosures and claims. Indeed, the embodiments described herein may be embodied in a variety of other forms.

## Claims

1. A multilayer board structure comprising:
a plurality of light emitting devices, each light emitting device of the plurality of light emitting devices having a plurality of electrodes formed on a terminal surface thereof; and
a multilayer board including a plurality of stacked substrates and implemented with the plurality of light emitting devices, wherein:
an uppermost substrate of the plurality of stacked substrates has a surface formed with metal layers coupling electrodes of the plurality of light emitting devices,
remaining substrates of the plurality of stacked substrates, other than the uppermost substrate, have surfaces formed with metal layers, respectively, and
a number of metal layers located directly below the electrodes of the plurality of light emitting devices is the same for each of the electrodes.

2. The multilayer board structure as claimed in claim 1, wherein an equal number of additional metal layers are formed directly below each of the electrodes of the plurality of light emitting devices.

3. The multilayer board structure as claimed in claim 1 or 2, wherein:
each light emitting device of the plurality of light emitting devices includes a first light emitting element configured to emit red light, a second light emitting element configured to emit green light, and a third light emitting element configured to emit blue light, and
the electrodes of each light emitting device of the plurality of light emitting devices include a first electrode coupled to the first light emitting element, a second electrode coupled to the second light emitting element, a third electrode coupled to the third light emitting element, and a fourth electrode coupled in common to cathodes or anodes of the first, second, and third light emitting elements.

4. The multilayer board structure as claimed in claim 3, wherein the metal layers formed on the surface of a lowermost substrate of the plurality of substrates include a metal layer coupled to the fourth electrode.

5. The multilayer board structure as claimed in claim 4, wherein the metal layers formed on the surface of the lowermost substrate of the plurality of substrates include dummy metal layers located directly below the electrodes of the plurality of light emitting devices.

6. The multilayer board structure as claimed in claim 5, wherein metal layers formed on a surface of an intermediate substrate of the plurality of substrates, other than and interposed between the uppermost substrate and the lowermost substrate, include other dummy metal layers coupled to the dummy metal layers.

7. The multilayer board structure as claimed in one of claims 3 to 6, wherein:
the multilayer board includes a stack of four substrates including the uppermost first substrate, a second substrate, a third substrate, and a fourth lowermost substrate,
the metal layers formed on the surfaces of the second substrate and the third substrate include wirings for the first light emitting element, the second light emitting element, and the third light emitting element, respectively, and
the metal layers formed on the surface of the fourth substrate include a wiring common to the first light emitting element, the second light emitting element, and the third light emitting element.

8. The multilayer board structure as claimed in one of claims 1 to 7, wherein the plurality of substrates of the multilayer board include a stack of a plurality of flexible film substrates.

9. A display device comprising:
the multilayer board structure according to one of claims 1 to 8.
